# EUROPÄISCHE PATENTSCHRIFT

(11) **EP 0 582 253 B1**
(45) Veröffentlichungstag und Bekanntmachung des Hinweises auf die Patenterteilung: **21.01.1998**
(21) Anmeldenummer: 93112358.2
(22) Anmeldetag: 02.08.1993
(51) Int. Cl.: G03F 7/20

(54) **Nachbehandlungsgerät für bildmässig belichtete Druckplatten**
Apparatus for the posttreatment of image-wise exposed printing plates
Appareil pour le posttraitement de plaques d'impression exposées

(30) Priorität: 05.08.1992 DE 4225831
(43) Veröffentlichungstag der Anmeldung: 09.02.1994
(73) Patentinhaber: Agfa-Gevaert AG, 51373 Leverkusen (DE)
(72) Erfinder: Zertani, Rudolf Dr., D-55234 Bechtolsheim (DE); Krämer, Norbert, D-65321 Heidenrod (DE); Haberhauer, Helmuth, D-65232 Taunusstein (DE)

(56) Entgegenhaltungen:
- EP-A- 0 450 486
- DE-U- 9 210 462
- PATENT ABSTRACTS OF JAPAN vol. 12, no. 274 (M-725) 29. Juli 1988 & JP-A-63 057 262 (FUJI XEROX CO LTD) 11. März 1988

## Beschreibung

Die Erfindung betrifft ein Nachbehandlungsgerät für bildmäßig belichtete Druckplatten, mit einer Belichtungsstation, die einer Wärmestation vorgeschaltet ist, in der in einem an drei Seiten mit einer Isolation ausgekleideten Gehäuse eine IR-Strahlungsquelle angeordnet ist, die nach unten hin durch das unten offene Gehäuse auf einen Reflektortisch abstrahlt, über den hinweg die Druckplatte durch das Nachbehandlungsgerät hindurchläuft.

Ein derartiges Gerät ist aus der EP-A - 0 450 486 (DE-A 40 11 023) bekannt. Die in diesem Gerät verwendete Leuchtstofflampe mit vorgelegtem Farbfilter in der Belichtungsstation zeigt bei Alterung eine spektrale Veränderung, die sich auf die optimale Belichtung der Druckplatten nachteilig auswirkt, da diese nur in einem engen Spektralbereich auftritt.

Aus der DE-B 12 14 085 (US-PS 3,144,331) ist es bekannt, zur Wiederherstellung der Empfindlichkeit fotopolymerisierbare Aufzeichnungsmaterialien, die als lichtempfindliche Schicht auf einem Druckplattenträger aufgetragen sind und deren Empfindlichkeit durch Absorption von molekularem Sauerstoff nachgelassen hat, mit 70 bis 98 % der Strahlungsmenge einer aktinischen Strahlung zu belichten, die bei gleichmäßigem Auftreffen zur Einleitung einer Fotopolymerisation notwendig wäre. Die Belichtung erfolgt durch den beispielsweise transparenten Druckplattenträger hindurch, wobei eine aktinische Strahlung mit einer solchen Wellenlänge verwendet wird, daß nur 10 bis 70 % der Strahlung von der fotopolymerisierbaren Schicht absorbiert werden. Bei diesem Verfahren wird im Prinzip einmal diffus und einmal bildmäßig belichtet. Die Diffus- bzw. Vorbelichtung erfolgt mit geringerer Intensität, nämlich mit 70 bis 98 % der Strahlungsintensität, die zum Erreichen der vollen Belichtungswirkung erforderlich ist. An diese Vorbelichtung schließt dann die bildmäßige Belichtung mit voller Strahlungsintensität an.

In der US-PS 4,298,803 ist ein Verfahren beschrieben, bei dem eine Fotoresistschicht mit einer Intensität vorbelichtet wird, die niedriger als die kritische Belichtungsintensität ist, bei der der Fotoresist an den belichteten Stellen weitgehend weggelöst werden kann. Nach dieser Vorbelichtung erfolgt die bildmäßige Belichtung der Fotoresistschicht. Die Reihenfolge der beiden Belichtungen kann vertauscht werden. In beiden Fällen wird die Lichtempfindlichkeit der Fotoresistschicht verbessert, wodurch die Bearbeitungszeit stark verkürzt wird. Bei der für dieses Verfahren eingesetzten Vorrichtung können sowohl die bildmäßige Belichtung als auch die Vor- bzw. Nachbelichtung des Fotoresists mittels eines Elektronenstrahls, einer UV- oder Röntgenstrahlenquelle erfolgen.

Aus der US-PS 4,716,097 ist gleichfalls ein Verfahren bekannt, bei dem eine fotopolymere Schicht, die einen Farbstoff enthält, zuerst mit Licht einer Wellenlänge oberhalb von 400 nm und einer Intensität von mindestens 1500 Lumen/m² diffus und danach bildmäßig belichtet wird.

In der deutschen Offenlegungsschrift DE-A 24 12 571 ist ein Verfahren zum Aushärten einer durch Licht härtbaren Polymerschicht einer Druckplatte beschrieben, bei dem zuerst diffus für kurze Zeit belichtet und danach bildmäßig so lange belichtet wird, bis die Polymerschicht praktisch vollständig in den belichteten Bereichen ausgehärtet ist. Die diffuse Belichtungsdauer beträgt maximal 90 % der Zeit, innerhalb welcher die vollständige Aushärtung der Polymerschicht bei gleicher Intensität der Strahlung sowohl für die Vorbelichtung als auch für die bildmäßige Belichtung erfolgt.

Aufgabe der Erfindung ist es, ein Nachbehandlungsgerät für bildmäßig belichtete Druckplatten so weiterzuentwickeln, daß eine spektrale Veränderung der Lichtquelle der Belichtungsstation durch Alterung nicht auftritt und eine gleichmäßige, regelbare Leuchtstärke über die volle Länge des jeweiligen Belichtungsabschnitts der Druckplatten erhalten wird.

Diese Aufgabe wird erfindungsgemäß in der Weise durch ein Nachbehandlungsgerät der eingangs beschriebenen Art gelöst, daß die Belichtungsstation eine durch eine Lichtstreuscheibe abgedeckte LED-Zeilenanordnung zur ganzflächigen Belichtung der Druckplatte enthält und daß die LED-Zeilenanordnung in einem Leuchtstärke- bzw. Leuchtleistungsbereich von 0 bis 100 % regelbar ist.

In Ausgestaltung der Erfindung strahlt die LED-Zeilenanordnung in einem Wellenlängenbereich von 565 ± 20 nm ab.

Die weitere Ausgestaltung der Erfindung ergibt sich aus den Merkmalen der Patentansprüche 3 bis 18.

Mit dem Nachbehandlungsgerät nach der Erfindung werden Fotopolymerdruckplatten, insbesondere Projektionsplatten und hochlichtempfindliche Laserplatten, verarbeitet, wobei durch die Nachbehandlung mit Licht sehr geringer und sehr gleichmäßiger Intensität und die Nacherwärmung die Standzeiten bzw. die Druckauflagenhöhe der so behandelten Druckplatten erheblich gesteigert werden können. Hierzu werden die bildmäßig belichteten Druckplatten, die beispielsweise in einem Laserbelichtungsgerät mit einer Wellenlänge von 488 nm belichtet wurden oder einer Projektionsbelichtung durch einen Quecksilber- oder Xenon-Strahler, Blitzlicht, Kohlenstofflampe oder dergleichen ausgesetzt waren, in dem Nachbehandlungsgerät mit Licht einer Wellenlänge λ = 565 ± 20 nm mit sehr geringer Intensität ein zweites Mal belichtet, d.h. nachbelichtet und anschließend auf eine Temperatur von 80 ° bis 120 ° C in dem gleichen Gerät nacherwärmt. Von Vorteil ist bei diesem Nachbehandlungsgerät, daß die Leuchtstärke der Belichtungsstation in sehr weiten Grenzen einstellbar ist.

Die Erfindung wird im folgenden anhand der Zeichnung näher erläutert. Es zeigen:
- Fig. 1: eine schematische Schnittansicht des behandlungsgeräts gemäß der Erfindung,
- Fig. 2-4: eine Seitenansicht und Draufsicht sowie die Schaltung einer LED-Zeilenanordnung einer Belichtungsstation des Nachbehandlungsgeräts,
- Fig. 5: im Schnitt eine Teilansicht des Reflektortisches des Nachbehandlungsgeräts, und
- Fig. 6: eine Draufsicht auf den Reflektortisch nach Figur 5.

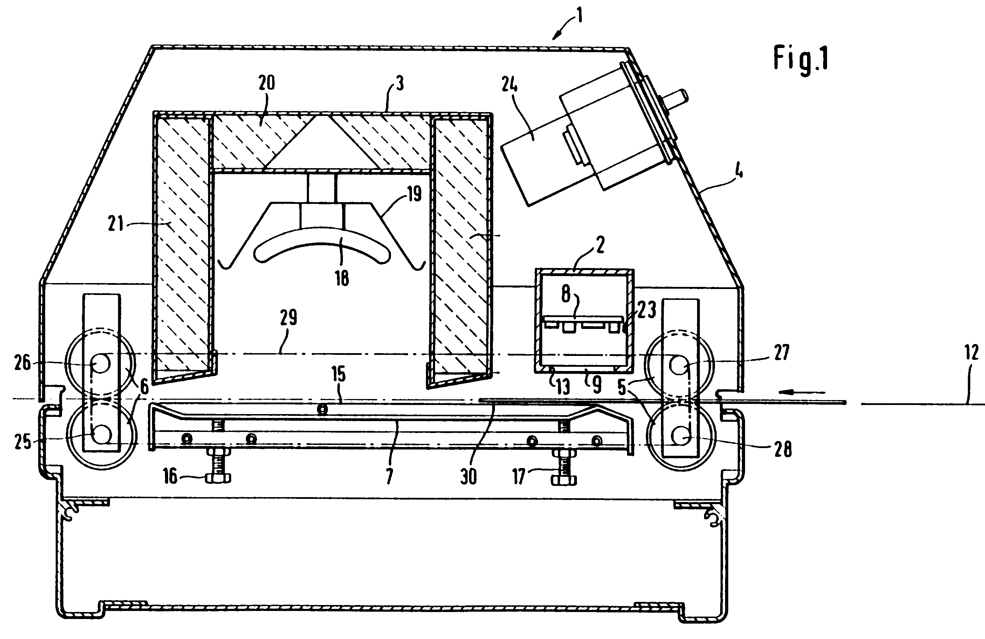

Ein Nachbehandlungsgerät 1 enthält als wesentliche Einheiten eine Belichtungsstation 2, eine Wärmestation 3, einen Reflektortisch 7 und Transportwalzenpaare 5 und 6, wobei diese Einheiten von einem Gehäuse 4 des Nachbehandlungsgeräts umschlossen sind. Druckplatten 30, von denen in Figur 1 eine schematisch dargestellt ist, durchlaufen entlang einer Transportbahn 12 das Nachbehandlungsgerät 1. Für den Transport der Druckplatte 30 durch das Nachbehandlungsgerät sind das Eingangstransportwalzenpaar 5 am Beginn der Transportbahn 12 innerhalb des Geräts und das Ausgangstransportwalzenpaar 6 am Ende der Transportbahn innerhalb des Geräts vorhanden. Auf den Wellen der Transportwalzen dieser beiden Transportwalzenpaare sitzen Stirnzahnräder 25, 26, 27 und 28 auf, über die eine endlos umlaufende Zahnradkette 29 geführt ist. Eine der Transportwalzen des Eingangswalzenpaares 5 wird durch einen nicht gezeigten Elektromotor angetrieben. Das Stirnzahnrad der angetriebenen Transportwalze versetzt die Zahnradkette 29 in Umlauf, wodurch der Synchronlauf zwischen dem Eingangs- und dem Ausgangswalzenpaar sichergestellt ist.

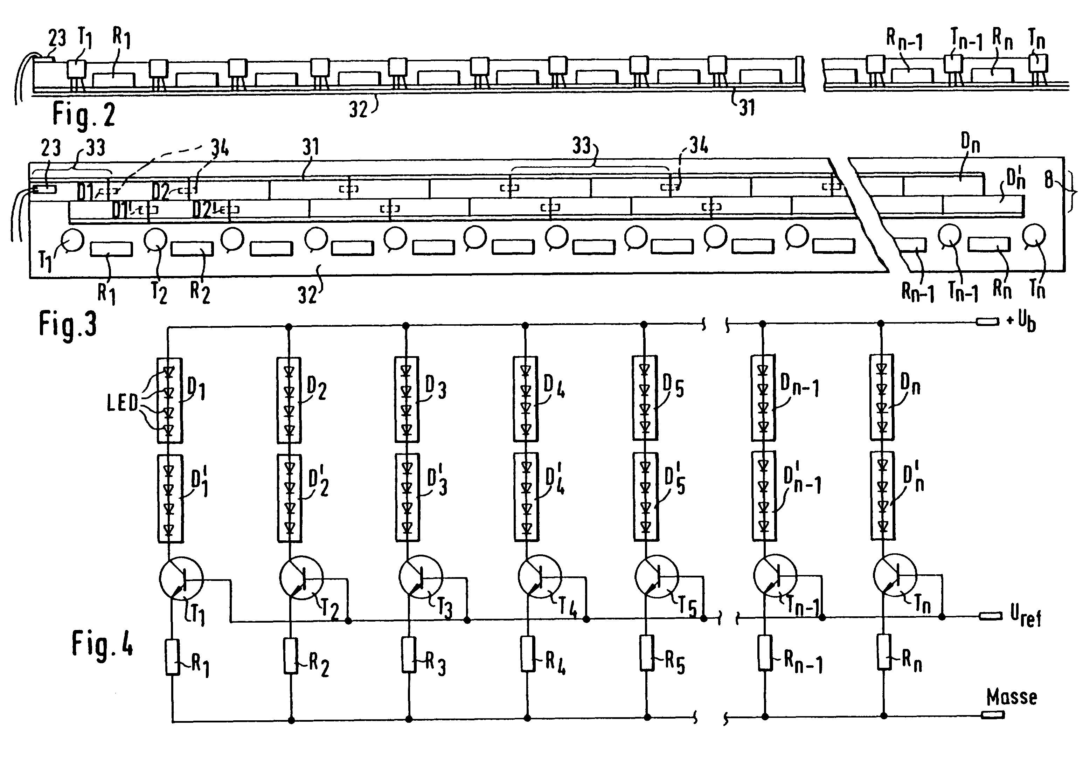

Die Belichtungsstation 2 ist der Wärmestation 3, betrachtet in Transportrichtung der Druckplatten, vorgeschaltet. In der Belichtungsstation 2 befindet sich als Strahlungsquelle eine LED-Zeilenanordnung 8 zur ganzflächigen, diffusen Belichtung der Druckplatte 30. Diese LED-Zeilenanordnung 8 besteht zumindest aus zwei zueinander versetzten Reihen von LED-Modulen D₁, D₂, ... Dₙ und D₁', D₂' ... Dₙ', wie die Figuren 2 und 3 zeigen, und befinden sich in einem geschlossenen Gehäuse der Belichtungsstation 2. Nach unten hin, in Richtung der Transportbahn 12 für die Druckplatten, weist das Gehäuse der Belichtungsstation 2 eine Belichtungsöffnung 13 auf, die von einer Lichtstreuscheibe 9 abgedeckt ist.

Das einzelne Modul D₁, ... Dₙ, D₁' ... Dₙ' besteht im allgemeinen aus vier Leuchtdioden LED, die, wie in Figur 4 gezeigt, in Reihe geschaltet sind. Zwei Module D₁, D₁'; D₂, D₂' ... Dₙ, Dₙ' sind jeweils in Reihe geschaltet und werden von einer nicht dargestellten Stromquelle mit einer Referenzspannung U_{ref} gespeist. Je zwei in Reihe geschaltete Module werden von einem Stromkreis aus Transistor Tᵢ und strombegrenzendem Widerstand Rᵢ, mit i = 1, 2, ... n, gesteuert. Der Widerstand Rᵢ kann ein Festwiderstand oder ein regelbarer Widerstand in Gestalt eines Potentiometers sein. Die Stromquelle beaufschlagt die Basen sämtlicher Transistoren Tᵢ, die parallel geschaltet sind, mit der Referenzspannung U_{ref}. Die gleichfalls parallel geschalteten Widerstände Rᵢ begrenzen die Emitterströme der Transistoren Tᵢ. Die Referenzspannung U_{ref} ist eine Gleichspannung im Bereich von 0 bis 3 V, es fließt dann ein Basis-Emitterstrom I_{BE} von 0 bis 30 mA, oder eine Rechteckspannung im Bereich von 0 bis 6 V, mit einem Basis-Emitterstrom I_{BE} von 0 bis 60 mA, mit einem Tastverhältnis von 1:2. Die Stromquelle der Referenzspannung U_{ref} liefert einen Strom in der Größenordnung von 100 mA und kann z.B. ein D/A-Wandler mit einer Pufferstufe oder eine separate Steuerschaltung sein.

Die effektive Leuchtstärke der LED-Zeilenanordnung 8 wird durch den Sensor 23 gemessen. Damit eine gleichmäßige Ausleuchtung über die gesamte Breite der LED-Zeilenanordnung 8 erhalten wird, werden LED-Module aus einer Fertigung verwendet. Treten dennoch Helligkeitsunterschiede zwischen den einzelnen Modulen auf, so werden sie durch Verändern des zugehörigen Widerstandes Rᵢ ausgeglichen.

Die LED-Module D₁, D₁', ... Dₙ, Dₙ' sind auf Segmenten 33 angeordnet, die gleiche oder unterschiedliche Längen haben und werden mittels Steckkontakten 34 zu einer Platine 31, wie aus Fig. 3 ersichtlich, zusammengesteckt. Auf dem einzelnen Segment 33 kann ein einzelnes oder zwei bis vier Module angebracht sein. Die Steckkontakte 34 sind in Fig. 3 gestrichelt angedeutet. Je ein Segment 33 mit einem und mit zwei Modulen der oberen Reihe der LED-Zeilenanordnung 8 ist durch eine geschwungene Klammer markiert. Die zusammengesteckte Platine 31 ist auf einer Grundplatine 32 befestigt, auf der auch die Transistoren Tᵢ und Widerstände Rᵢ angeordnet sind. Da die einzelnen Segmente 33 unterschiedliche Längen haben können, ist die Reihenlänge an die Breite der zu belichtenden Druckplatte anpaßbar. Durch die segmentierte Bauweise der LED-Zeilenanordnung 8 ist bei einem Ausfall von einem oder mehreren LED-Modulen ein schneller Austausch möglich, da die funktionierenden Bauteile nicht ausgebaut werden müssen. Bei der Alterung der LED tritt keine spektrale Veränderung, d.h. keine Verschiebung des ausgesandten Wellenlängenbereiches auf. Durch die Stromregelung der LED-Module ist eine gleichmäßige Leuchtleistung über die volle Länge der LED-Zeilenanordnung 8 einstellbar, die mit Niederspannung betrieben wird.

Die Beleuchtungsstärke der LED-Zahlenanordnung 8 der Belichtungsstation 2 ist zur genauen Dosierung der auf die Druckplatte 30 applizierten Lichtmenge elektronisch stufenlos zwischen 0 % und 100 % der maximalen Beleuchtungsstärke regelbar. Die Anzeige der Beleuchtungsstärke dieser LED-Zeilenanordnung 8 erfolgt digital, wobei zur Messung der Beleuchtungsstärke ein Sensor 23 im Inneren des Gehäuses der Belichtungsstation 2 angebracht ist. Die Geschlossenheit des Gehäuses verhindert das Auftreten von äußeren Störstrahlungen, die die Messung der Beleuchtungsstärke mittels des Sensors 23 in unerwünschter Weise beeinträchtigen könnten.

Die Einstellung der Beleuchtungsstärke der LED-Zeilenanordnung 8 erfolgt durch eine elektronische Regelung 24, die oberhalb der Belichtungsstation 2 schematisch dargestellt ist.

Die spektrale Verteilung der LED-Zeilenanordnung 8 liegt im Wellenlängenbereich von 565 ± 20 nm.

Der Sensor 23 zur Messung der Beleuchtungsstärke ist üblicherweise eine Fotodiode, die sich im Gehäuse der Belichtungsstation 2 befindet und dadurch von jeglicher Störstrahlung, wie beispielsweise in das Nachbehandlungsgerät 1 einfallendes Tageslicht, abgeschirmt ist. Zweckmäßigerweise ist die Fotodiode oberhalb der Platine 31 angebracht (vgl. Fig. 2).

Die Wärmestation 3 ist mit einer IR-Strahlungsquelle 18 ausgerüstet, die in einem Gehäuse untergebracht ist, das an drei Seiten mit einer Isolation 20, 21, 22 wärmeisoliert ist. Nach unten hin ist das Gehäuse auf den Reflektortisch 7 hin offen, über den die Druckplatte 30 durch das Nachbehandlungsgerät 1 hindurchgeführt wird. Bei der Strahlungsquelle 18 der Wärmestation 3 handelt es sich beispielsweise um einen Infrarot-Dunkelstrahler aus Keramik, der Strahlung in einem Wellenlängenbereich weitab sowohl vom sichtbaren Wellenlängenbereich als auch vom Strahlungsempfindlichkeitsbereich der Druckplatten emittiert. Oberhalb der IR-Strahlungsquelle 18 ist ein Reflektor 19 angebracht. Die von der IR-Strahlungsquelle 18 emittierte Strahlung liegt in einem Wellenlängenbereich von 1000 nm bis über 10000 nm. Durch diesen Spektralbereich der Wärmestrahlung sind voneinander völlig unabhängige Dosierungen der auf die Druckplatten 30 einwirkenden elektromagnetischen Strahlungen möglich, nämlich einerseits die voranstehend erwähnte Infrarotstrahlung zur Erzeugung von Wärme und andererseits die diffuse Belichtung mit sichtbarem Licht zur sogenannten "Nachbelichtung" der schon bildmäßig belichteten Druckplatte.

Die IR-Strahlungsquelle 18 ist in ihrer Strahlungsleistung so regelbar, daß die Druckplatte 30 auf eine Temperatur von 80 ° bis 120 °C erwärmt werden kann.

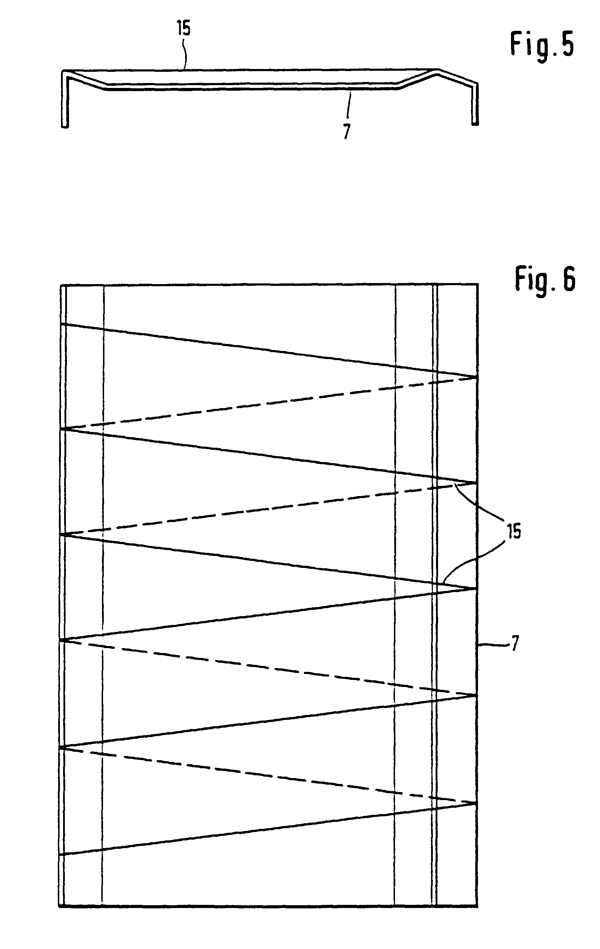

Der Reflektortisch 7 ist als ein trogähnlicher Hohlkörper geformt, der auf der Höhe der Transportbahn 12 der Druckplatten 30 eine Bespannung 15 aufweist, wie aus den Figuren 5 und 6 ersichtlich ist. Die Bespannung 15 besteht entweder aus einem dünnen Metalldraht oder einem dünnen Kunststoffaden und ist auf der Oberseite des Reflektortisches V-förmig aufgespannt (vgl. Fig. 3), damit die vorderen Ecken der Druckplatte beim Transport durch das Nachbehandlungsgerät 1 nicht unterhalb der Bespannung gelangen können, was einen Druckplattenstau zur Folge hätte.

Durch die sehr geringe Wärmekapazität der Bespannung 15 im Vergleich zu der Druckplatte 30 ist gewährleistet, daß an keiner Stelle der Druckplatte während der Erwärmung im Bereich unterhalb der Wärmestation 3 ein Wärmeabfluß entstehen kann, der zu einer ungleichmäßigen Erwärmung der Druckplatte führen könnte. Die Innenseite des Reflektortisches 7 ist mit einem wärmereflektierenden Metallblech ausgekleidet. An der Unterseite des Reflektortisches befinden sich Verstelleinrichtungen 16, 17, üblicherweise Stellschrauben, die ein Anheben und Absenken innerhalb eines kleinen Bereiches der Grundfläche des trogähnlichen Reflektortisches 7 ermöglichen, um so den Abstand der Unterseite der Druckplatte zu der Grundfläche des Reflektortisches in einem bestimmten Maße einstellen zu können.

Ein Wärmeabfluß von der Druckplatte, beispielsweise durch Berührung zwischen der Druckplatte und dem Metallblech des Reflektortisches, könnte zu einer partiellen Temperaturabsenkung im Bereich der Berührungsfläche führen und damit zu einer ungleichmäßigen Erwärmung und somit auch ungleichmäßigen Nachhärtung der Fotopolymerschicht der Druckplatte.

Mit dem Nachbehandlungsgerät werden die Vorteile erzielt, daß die LED-Zeilenanordnung 8 der Belichtungsstation 2 über die Arbeitsbreite der Druckplatte 30 eine sehr gleichmäßige Belichtungsstärke erzeugt, und die Belichtungsintensität der LED-Module bzw. der LED-Zeilenanordnung 8 stufenlos geregelt werden kann. Die Ergebnisse der Belichtung für unterschiedliche Belichtungsintensitäten sind stets reproduzierbar. Eine Alterung der LED-Module verursacht keine spektrale Verschiebung, so daß die ausgesandte Wellenlänge weitgehend konstant bleibt. Weitere Vorteile des Nachbehandlungsgerätes bestehen darin, daß keine Störstrahlungen im Bereich der Belichtungs- und der Wärmestation auftreten können, daß die LED-Zeilenanordnung 8 in ihrer Länge beliebig konfigurierbar ist und in ihrer vollen Länge zum Belichten genutzt werden kann und daß sie mit Niederspannung betrieben und im Bereich von 0 bis 100 % ihrer Leuchtleistung einstellbar ist.

## Patentansprüche

1. Nachbehandlungsgerät für bildmäßig belichtete Druckplatten, mit einer Belichtungsstation, die einer Wärmestation vorgeschaltet ist, in der in einem an drei Seiten mit einer Isolation ausgekleideten Gehäuse eine IR-Strahlungsquelle angeordnet ist, die nach unten hin durch das unten offene Gehäuse auf einen Reflektortisch abstrahlt, über den hinweg die Druckplatte durch das Nachbehandlungsgerät hindurchläuft, dadurch gekennzeichnet, daß die Belichtungsstation (2) eine durch eine Lichtstreuscheibe (9) abgedeckte LED-Zeilenanordnung (8) zur ganzflächigen Belichtung der Druckplatte (30) enthält und daß die LED-Zeilenanordnung (8) in einem Leuchtstärke- bzw. Leuchtleistungsbereich von 0 bis 100 % regelbar ist.

2. Nachbehandlungsgerät nach Anspruch 1, dadurch gekennzeichnet, daß die LED-Zeilenanordnung (8) in einem Wellenlängenbereich von 565 ± 20 nm abstrahlt.

3. Nachbehandlungsgerät nach Anspruch 1, dadurch gekennzeichnet, daß die LED-Zeilenanordnung (8) zumindest aus zwei zueinander versetzten Reihen von LED-Modulen (Dᵢ; Dᵢ') besteht und daß das einzelne Modul (Dᵢ; Dᵢ') aus mehreren Leuchtdioden zusammengesetzt ist.

4. Nachbehandlungsgerät nach Anspruch 3, dadurch gekennzeichnet, daß das einzelne Modul vier Leuchtdioden LED enthält, die in Reihe geschaltet sind.

5. Nachbehandlungsgerät nach Anspruch 3, dadurch gekennzeichnet, daß jeweils zwei Module (D₁, D₁'; D₂, D₂'; ... Dₙ, Dₙ') in Reihe geschaltet sind und von einem Stromkreis aus je einem Transistor (T₁; T₂; ... Tₙ), regelbaren oder festen Widerstand (R₁; R₂; ... Rₙ) und einer gemeinsamen Stromquelle für alle Module, die eine Referenzspannung U_{ref} an die Basis der Transistoren liefert, gesteuert sind.

6. Nachbehandlungsgerät nach Anspruch 5, dadurch gekennzeichnet, daß die Basen aller Transistoren (T₁, T₂, ... Tₙ) parallel und alle Widerstände (R₁, R₂, ... Rₙ) zwischen den Emittern der Transistoren und einer Masse-Leitung parallel geschaltet sind.

7. Nachbehandlungsgerät nach Anspruch 5, dadurch gekennzeichnet, daß die Referenzspannung U_{ref} eine Gleich- oder eine Rechteckspannung mit einem Tastverhältnis 1:2 ist.

8. Nachbehandlungsgerät nach Anspruch 1, dadurch gekennzeichnet, daß ein Sensor (23) zur Messung der Leuchtstärke der LED-Zeilenanordnung (8) in der Belichtungsstation (2) vorhanden ist.

9. Nachbehandlungsgerät nach Anspruch 3, dadurch gekennzeichnet, daß die LED-Zeilenanordnung (8) aus einzelnen Segmenten (33) besteht, die mittels Steckkontakten (34) zu einer Platine (31) zusammengesteckt sind.

10. Nachbehandlungsgerät nach Anspruch 9, dadurch gekennzeichnet, daß die Segmente (33) unterschiedliche oder gleiche Längen aufweisen.

11. Nachbehandlungsgerät nach Anspruch 8 oder 9, dadurch gekennzeichnet, daß die LED-Zeilenanordnung (8) in einem Gehäuse eingebaut ist, dessen untere Öffnung durch die Lichtstreuscheibe (9) abgedeckt ist und daß im Inneren des Gehäuses als Sensor (23) eine Fotodiode oberhalb der Platine (31) angeordnet ist.

12. Nachbehandlungsgerät nach Anspruch 1, dadurch gekennzeichnet, daß die IR-Strahlungsquelle (18) der Wärmestation (3) ein Infrarot-Dunkelstrahler aus Keramik ist, der Strahlung in einem Wellenlängenbereich weitab sowohl vom sichtbaren Wellenlängenbereich als auch vom Strahlungsempfindlichkeitsbereich der Druckplatten emittiert.

13. Nachbehandlungsgerät nach Anspruch 12, dadurch gekennzeichnet, daß die IR-Strahlungsquelle (18) Strahlung in einem Wellenlängenbereich von 1000 bis 10000 nm emittiert.

14. Nachbehandlungsgerät nach Anspruch 13, dadurch gekennzeichnet, daß die IR-Strahlungsquelle (18) in ihrer Strahlungsleistung so regelbar ist, daß die Druckplatte (30) auf eine Temperatur von 80 °C bis 120 °C erwärmbar ist.

15. Nachbehandlungsgerät nach Anspruch 1, dadurch gekennzeichnet, daß der Reflektortisch (7) als trogähnlicher Hohlkörper geformt ist, der auf der Höhe der Transportbahn (12) der Druckplatten (30) eine Bespannung (15) aufweist.

16. Nachbehandlungsgerät nach Anspruch 15, dadurch gekennzeichnet, daß die Bespannung (15) aus einem dünnen Metalldraht oder einem dünnen Kunststoffaden besteht und V-förmig auf der Oberseite des Reflektortisches (7) aufgespannt ist.

17. Nachbehandlungsgerät nach Anspruch 14, dadurch gekennzeichnet, daß die Innenseite des Reflektortisches (7) mit einem wärmereflektierenden Metallblech ausgekleidet ist.

18. Nachbehandlungsgerät nach Anspruch 1, dadurch gekennzeichnet, daß für den Transport der Druckplatten (30) entlang einer Transportbahn (12) durch das Nachbehandlungsgerät ein Eingangs- und ein Ausgangstransportwalzenpaar (5, 6) vorhanden sind, die sich im Gehäuseinneren befinden und synchron von einer endlos umlaufenden Zahnradkette (29) angetrieben sind, die über Stirnzahnräder (25, 26, 27, 28) geführt ist, wobei die Stirnzahnräder auf den Wellen der Transportwalzen der beiden Transportwalzenpaare aufsitzen und eine der Transportwalzen des Eingangswalzenpaares (5) motorisch angetrieben ist.

## Claims

1. Post-treatment device for photographically exposed printing plates, having an exposure station disposed upstream of a heat station which has, disposed in a housing lined on three sides with insulation, an IR radiation source which radiates in a downward direction through the open-bottomed housing onto a reflector table, across which the printing plate runs through the post-treatment device, characterized in that the exposure station (2) comprises an LED linear array (8) covered by a light diffusion disc (9) for exposing the entire surface of the printing plate (30) and that the LED linear array (8) is controllable within a luminosity or luminous power range of 0 to 100%.

2. Post-treatment device according to claim 1, characterized in that the LED linear array (8) radiates in a wavelength range of 565 ± 20 nm.

3. Post-treatment device according to claim 1, characterized in that the LED linear array (8) comprises at least two staggered rows of LED modules (Dᵢ; Dᵢ') and that the individual module (D₁; Dᵢ') is composed of a plurality of light-emitting diodes.

4. Post-treatment device according to claim 3, characterized in that the individual module comprises four light-emitting diodes LED which are connected in series.

5. Post-treatment device according to claim 3, characterized in that in each case two modules (D₁, D₁'; D₂, D₂'; ... Dₙ, Dₙ') are connected in series and controlled by a circuit comprising in each case a transistor (T₁; T₂; ... Tₙ), a rheostat or invariable resistor (R₁; R₂; ... Rₙ) and a common power source for all modules, which supplies a reference voltage U_{ref} to the bases of the transistors.

6. Post-treatment device according to claim 5, characterized in that the bases of all of the transistors (T₁, T₂ ... Tₙ) are connected in parallel and all of the resistors (R₁, R₂ ... Rₙ) are connected in parallel between the emitters of the transistors and an earthing line.

7. Post-treatment device according to claim 5, characterized in that the reference voltage U_{ref} is a direct voltage or a square-wave voltage with a pulse duty factor of 1:2.

8. Post-treatment device according to claim 1, characterized in that a sensor (23) for measuring the luminosity of the LED linear array (8) is provided in the exposure station (2).

9. Post-treatment device according to claim 3, characterized in that the LED linear array (8) comprises individual segments (33) which are assembled by means of plug-in contacts (34) into a printed circuit board (31).

10. Post-treatment device according to claim 9, characterized in that the segments (33) are of differing or identical lengths.

11. Post-treatment device according to claim 8 or 9, characterized in that the LED linear array (8) is installed in a housing, the bottom opening of which is covered by a light diffusion disc (9), and that inside the housing a photodiode is disposed as sensor (23) above the printed circuit board (31).

12. Post-treatment device according to claim 1, characterized in that the IR radiation source (18) of the heat station (3) is an infrared dark radiator made of ceramic material, which emits radiation in a wavelength range far away from both the visible wavelength range and the radiation sensitivity range of the printing plates.

13. Post-treatment device according to claim 12, characterized in that the IR radiation source (18) emits radiation in a wavelength range of 1000 to 10000 nm.

14. Post-treatment device according to claim 13, characterized in that the radiated power of the IR radiation source (18) is controllable in such a way that the printing plate (30) is heatable up to a temperature of 80° C to 120° C.

15. Post-treatment device according to claim 1, characterized in that the reflector table (7) takes the form of a trough-like hollow body which at the level of the transport path (12) of the printing plates (30) has a covering (15).

16. Post-treatment device according to claim 15, characterized in that the covering (15) comprises a thin metal wire or a thin synthetic fibre and is clamped in a V-shaped manner at the top of the reflector table (7).

17. Post-treatment device according to claim 14, characterized in that the inside of the reflector table (7) is lined with a heat-reflecting metal sheet.

18. Post-treatment device according to claim 1, characterized in that for conveying the printing plates (30) along a transport path (12) through the post-treatment device, an inlet and an outlet transport roller pair (5, 6) are provided, which are situated inside the housing and driven synchronously by a continuously rotating toothed wheel chain (29) which is conveyed via spur-toothed wheels (25, 26, 27, 28), the spur-toothed wheels being seated on the shafts of the transport rollers of the two transport roller pairs and one of the transport rollers of the inlet transport roller pair (5) being motor-driven.

## Revendications

1. Appareil de post-traitement pour plaques d'impression exposées selon une image, comportant un poste d'exposition qui précède un poste de chauffage dans lequel, dans une enceinte revêtue d'une isolation sur trois côtés, est disposée une source de rayonnement IR qui rayonne vers le bas, à travers l'enceinte ouverte en bas, sur un plateau réflecteur au-dessus duquel la plaque d'impression traverse l'appareil de post-traitement, caractérisé en ce que le poste d'exposition (2) contient un agencement de rangées de DEL (8) recouvert par une plaque de dispersion de la lumière (9) pour l'exposition de la plaque d'impression (30) sur toute la surface et en ce que l'agencement de rangées de DEL (8) est réglable dans un domaine de luminosité ou de puissance d'éclairement de 0 à 100 %.

2. Appareil de post-traitement selon la revendication 1, caractérisé en ce que l'agencement de rangées de DEL (8) rayonne dans un domaine de longueurs d'onde de 565 ± 20 nm.

3. Appareil de post-traitement selon la revendication 1, caractérisé en ce que l'agencement de rangées de DEL (8) consiste en au moins deux rangées mutuellement décalées de modules de DEL (Dᵢ ; D_{i'}) et en ce que le module individuel (Dᵢ ; D_{i'}) est composé de plusieurs diodes électroluminescentes.

4. Appareil de post-traitement selon la revendication 3, caractérisé en ce que le module individuel contient quatre diodes électroluminescentes DEL qui sont branchées en série.

5. Appareil de post-traitement selon la revendication 3, caractérisé en ce que, à chaque fois, deux modules (D₁, D_{1'} ; D₂, D_{2'} ; ... Dₙ, D_{n'}) sont branchés en série et sont commandés par un circuit constitué dans chaque cas par un transistor (T₁ ; T₂ ; ... Tₙ), une résistance réglable ou fixe (R₁ ; R₂ ; ... Rₙ) et une source de courant commune pour tous les modules qui délivre une tension de référence U_{ref} à la base des transistors.

6. Appareil de post-traitement selon la revendication 5, caractérisé en ce que les bases de tous les transistors (T₁, T₂, ... Tₙ) sont branchées en parallèle et toutes les résistances (R₁, R₂, ... Rₙ) sont branchées en parallèle entre les émetteurs des transistors et un conducteur de masse.

7. Appareil de post-traitement selon la revendication 5, caractérisé en ce que la tension de référence U_{ref} est une tension continue ou carrée ayant un rapport durée de passage/durée de cycle de 1 : 2.

8. Appareil de post-traitement selon la revendication 1, caractérisé en ce qu'un capteur (23) pour la mesure de la luminosité de l'agencement de rangées de DEL (8) est présent dans le poste d'exposition (2).

9. Appareil de post-traitement selon la revendication 3, caractérisé en ce que l'agencement de rangées de DEL (8) consiste en segments individuels (33) qui sont assemblés en une platine (31) au moyen de contacts à fiches (34).

10. Appareil de post-traitement selon la revendication 9, caractérisé en ce que les segments (33) présentent des longueurs différentes ou égales.

11. Appareil de post-traitement selon la revendication 8 ou 9, caractérisé en ce que l'agencement de rangées de DEL (8) est incorporé dans un boîtier dont l'ouverture inférieure est recouverte par la plaque de dispersion de la lumière (9) et en ce qu'une photodiode est disposée au-dessus de la platine (31) comme capteur (23) à l'intérieur du boîtier.

12. Appareil de post-traitement selon la revendication 1, caractérisé en ce que la source de rayonnement IR (18) du poste de chauffage (3) est un radiateur obscur infrarouge en céramique qui émet un rayonnement dans un domaine de longueurs d'onde distant aussi bien du domaine de longueurs d'onde visible que du domaine de sensibilité aux rayonnements de la plaque d'impression.

13. Appareil de post-traitement selon la revendication 12, caractérisé en ce que la source de rayonnement IR (18) émet un rayonnement dans un domaine de longueurs d'onde de 1 000 à 10 000 nm.

14. Appareil de post-traitement selon la revendication 13, caractérisé en ce que la source de rayonnement IR (18) est réglable en ce qui concerne sa puissance de rayonnement de telle manière que la plaque d'impression (30) est chauffable à une température de 80°C à 120°C.

15. Appareil de post-traitement selon la revendication 1, caractérisé en ce que le plateau réflecteur (7) est sous forme de corps creux analogue à une auge qui comporte un revêtement (15) à la hauteur de la bande transporteuse (12) des plaques d'impression (30).

16. Appareil de post-traitement selon la revendication 15, caractérisé en ce que le revêtement (15) consiste en un fil métallique mince ou en un fil de matière plastique mince et est tendu en forme de V sur le côté supérieur du plateau réflecteur (7).

17. Appareil de post-traitement selon la revendication 14, caractérisé en ce que le côté interne du plateau réflecteur (7) est revêtu d'une tôle métallique réfléchissant la chaleur.

18. Appareil de post-traitement selon la revendication 1, caractérisé en ce que, pour le transport des plaques d'impression (30) le long d'une bande transporteuse (12) à travers l'appareil de post-traitement, il est prévu une paire de cylindres de transport d'entrée et une paire de cylindres de transport de sortie (5, 6) qui se trouvent à l'intérieur du boîtier et qui sont entraînées de manière synchrone par une chaîne à roues dentées (29) sans fin qui est guidée sur des roues dentées frontales (25, 26, 27, 28), les roues dentées frontales étant montées sur les arbres des cylindres de transport des deux paires de cylindres de transport et l'un des cylindres de transport de la paire de cylindres d'entrée (5) étant entraîné de manière motorisée.
